# EUROPEAN PATENT APPLICATION

(11) **EP 4 617 242 A1**
(43) Date of publication of application: **17.09.2025**
(21) Application number: 23888708.7
(22) Date of filing: 07.11.2023
(51) Int. Cl.: C03C 3/091, H05K 1/03

(54) **GLASS SUBSTRATE FOR REINFORCING WIRING BOARD**

(30) Priority: 11.11.2022 JP 2022180728
(71) Applicant: Nippon Electric Glass Co., Ltd., Otsu-shi, Shiga 520-8639 (JP)
(72) Inventor: KIMURA, Miki, Otsu-shi Shiga 520-8639 (JP); HAYASHI, Masahiro, Otsu-shi Shiga 520-8639 (JP); KAWAMOTO, Kosuke, Otsu-shi Shiga 520-8639 (JP); SUZUKI, Ryota, Otsu-shi Shiga 520-8639 (JP); MURATA, Takashi, Otsu-shi Shiga 520-8639 (JP); OKUNAGA, Kiyoyuki, Otsu-shi Shiga 520-8639 (JP)
(74) Representative: Tetzner, Michael
(86) International application number: PCT/JP2023/040078
(87) International publication number: WO 2024/101361

(57) **Abstract**

Provided is a glass substrate for reinforcing a wiring board having an excellent low dielectric loss characteristic. The glass substrate for reinforcing a wiring board includes a sheet glass having as a glass composition, in terms of mol%, a content of SiO₂+Al₂O₃+B₂O₃ of 87% or more, and having a thickness "t" of 5 µm or more and 500 µm or less.

## Description

### Technical Field

The present invention relates to a glass substrate to be used as a prepreg or a core material for a wiring board.

### Background Art

In recent years, a wiring board such as a printed wiring board having a low dielectric loss has been required as a next generation communication member. Hitherto, a substrate obtained by impregnating a glass cloth, which is a fabric having a glass fiber woven thereinto, with a resin has been used as a prepreg or a core material for a printed wiring board. A cloth including E-glass has been generally used for a substate thus far, but such cloth has a disadvantage of a high dielectric loss, particularly in high-frequency applications. Accordingly, in Patent Literature 1, a cloth including a quartz glass fiber having a lower dielectric loss is used for a substate. When such cloth is used for a substrate at high frequencies, a skin effect in which a current easily flows in a vicinity of a surface of wiring is liable to become noticeable, and when unevenness of a substrate surface is large, signal transmission requires time. Thus, a transmission loss is liable to be increased.

A substrate obtained by impregnating a glass cloth with a resin tends to have locally differing glass-to-resin ratios. When the glass-to-resin ratio differs, the transmission loss also differs, which may cause a change in signal waveform and a delay in signal propagation. Improvement in performance and reduction in weight of the substrate are also important, and hence it is effective to reduce the thickness of a prepreg or a core material. Accordingly, a glass cloth including a fiber having a small diameter and the like have been proposed. However, the reduction in diameter of the fiber tends to reduce the rigidity of each of the prepreg and the core material, and at the same time, tends to expand the interface between the glass and the resin. When an air gap or foreign matter exists at an interface between different materials, disconnection of a circuit and the like may occur. Thus, the area of the interface between the glass and the resin is preferably as small as possible. Accordingly, in Patent Literature 2, there is a proposal of a use of a sheet glass having regulated surface roughness instead of a cloth.

### Citation List

Patent Literature 1: JP 6999487 B2
Patent Literature 2: JP 2011-225777 A

### Summary of Invention

### Technical Problem

When the sheet glass is used as a prepreg or a core material for a printed wiring board, there is a problem in that the sheet glass has a large dielectric loss and desired low dielectric characteristics cannot be obtained. This tendency is noticeable particularly when the thickness of the sheet glass is reduced.

In view of the above-mentioned circumstances, an object of the present invention is to provide a glass substrate for reinforcing a wiring board having an excellent low dielectric loss characteristic.

### Solution to Problem

The inventors of the present invention have repeated various experiments, and as a result, have found that the above-mentioned technical object can be achieved by a glass substrate having a predetermined glass composition. Thus, the finding is proposed as the present invention.
(1) That is, according to an embodiment of the present invention, there is provided a glass substrate for reinforcing a wiring board, comprising a sheet glass having as a glass composition, in terms of mol%, a content of SiO₂+Al₂O₃+B₂O₃ of 87% or more, and having a thickness "t" of 5 µm or more and 500 µm or less. The term "SiO₂+Al₂O₃+B₂O₃" means the total content of SiO₂, Al₂O₃, and B₂O₃.
(2) In the glass substrate for reinforcing a wiring board according to the above-mentioned embodiment (1) of the present invention, the glass preferably has a fictive temperature of a glass transition temperature Tg+300°C or less.
   A wiring board to be used as a next generation communication member is sometimes laminated and mounted at high density to increase capacity. Accordingly, there is a tendency that a glass substrate serving as a reinforcing material is required to have a reduced thickness. When the thickness of the glass substrate is reduced, a cooling rate thereof is increased and a fictive temperature thereof is liable to be increased. As a result, the dielectric loss tends to be increased. The inventors of the present invention have focused on this point and have found that a low dielectric loss characteristic can be achieved by controlling the fictive temperature of the glass substrate as low as possible as described above.
(3) In the glass substrate for reinforcing a wiring board according to the above-mentioned embodiment (1) or (2) of the present invention, the sheet glass preferably has a width L of 5 mm or more and 1,000 mm or less.
(4) In the glass substrate for reinforcing a wiring board according to any one of the above-mentioned embodiments (1) to (3) of the present invention, the sheet glass preferably has a value for a ratio "t/L" of the thickness "t" to a width L of 0.01×10⁻³ or more and 20×10⁻³ or less.
(5) In the glass substrate for reinforcing a wiring board according to any one of the above-mentioned embodiments (1) to (4) of the present invention, the sheet glass preferably has a dielectric loss of 0.027 or less at 25°C and a frequency of 40 GHz.
(6) The glass substrate for reinforcing a wiring board according to any one of the above-mentioned embodiments (1) to (5) of the present invention is preferably used as a prepreg or a core material for a wiring board.
(7) According to an embodiment of the present invention, there is provided a prepreg, comprising: the sheet glass of any one of the above-mentioned embodiments (1) to (6); and a resin layer arranged on at least one main surface of the sheet glass.

### Advantageous Effects of Invention

According to the present invention, the glass substrate for reinforcing a wiring board having an excellent low dielectric loss characteristic can be provided.

### Description of Embodiments

A glass substrate for reinforcing a wiring board (hereinafter also simply referred to as "glass substrate") of the present invention is described in detail below.

The glass substrate of the present invention is formed of a sheet glass having a predetermined fictive temperature. The fictive temperature of a glass refers to a temperature at which a glass structure is frozen, and changes in accordance with a melting temperature, a cooling rate, and the temperature and time of annealing. When the fictive temperature of the glass is high, the glass structure becomes non-dense and the dielectric loss of the glass is liable to be increased. Accordingly, a suitable fictive temperature of the sheet glass is preferably a glass transition point Tg+300°C or less, Tg+290°C or less, Tg+250°C or less, Tg+230°C or less, Tg+200°C or less, Tg+180°C or less, Tg+160°C or less, Tg+150°C or less, Tg+130°C or less, Tg+100°C or less, Tg+80°C or less, or Tg+50°C or less, particularly preferably Tg+30°C or less. Meanwhile, in order to reduce the fictive temperature, the melting temperature needs to be reduced, the cooling rate needs to be reduced, or the annealing time needs to be increased, and hence the productivity of the glass is liable to be reduced. Thus, a suitable fictive temperature is preferably Tg-200°C, Tg-150°C, or Tg-100°C or more, particularly preferably Tg-75°C or more.

The fictive temperature of the sheet glass may be measured by a method described below. First, a density (density 1) of the sheet glass is measured by an Archimedes method. After that, the sheet glass is subjected to heat treatment in the vicinity of a range of a glass transition point Tg+300°C for 1 hour and cooled with water, and then a density (density 2) of the sheet glass is measured by the Archimedes method. This measurement is repeated at a plurality of heat treatment temperatures. In particular, it is preferred that the heat treatment temperature be set so that the density 2 is a value larger or smaller than that of the density 1. Thus, a graph showing a correlation of the density with respect to the heat treatment temperature can be obtained. In the resultant graph, a temperature corresponding to the density 1 is the fictive temperature. When the amount of a sample is small, density measurement by a heavy liquid method may be performed. When the sheet glass has resin wiring or metal wiring, a resin layer may be removed by removing the wiring with a ferric chloride solution and performing heat treatment at from 300°C to 500°C for several hours. After that, the fictive temperature of the sheet glass may be measured by the above-mentioned method.

A viscosity of the sheet glass at a fictive temperature is preferably 10^{9.0} dPa·s or more, 10^{9.3} dPa·s or more, 10^{9.5} dPa·s or more, or 10^{10.0} dPa·s or more, particularly preferably 10^{10.5} dPa·s or more. Meanwhile, in order to increase the viscosity at a fictive temperature, the melting temperature needs to be reduced, the cooling rate needs to be reduced, or the annealing time needs to be increased, and hence the productivity is liable to be reduced. Accordingly, an upper limit of the viscosity of the sheet glass at a fictive temperature is preferably 10^{14.0} dPa·s or less or 10^{13.5} dPa·s or less, particularly preferably 10^{13.0} dPa·s or less.

When a thickness "t" of the sheet glass is too small, the glass substrate of the present invention becomes difficult to handle and is liable to be broken in production of a prepreg or the like by using the glass substrate. In addition, when the thickness of the sheet glass is too small, the cooling rate of the glass is increased and the fictive temperature thereof tends to be increased. As a result, the dielectric loss is liable to be increased. Meanwhile, when the thickness "t" of the sheet glass is too large, a glass content in a prepreg employing the glass substrate of the present invention, for example, increases, and hence the dielectric loss of the prepreg as a whole may be increased. Accordingly, a lower limit of the thickness "t" of the sheet glass is preferably 5 µm or more, 8 µm or more, 10 µm or more, 15 µm or more, 18 µm or more, 20 µm or more, 25 µm or more, 30 µm or more, 35 µm or more, 40 µm or more, or 45 µm or more, particularly preferably 50 µm or more. Meanwhile, an upper limit of the thickness "t" of the sheet glass is preferably 500 µm or less, 450 µm or less, 400 µm or less, 350 µm or less, 300 µm or less, 250 µm or less, or 200 µm or less, particularly preferably 150 µm or less.

When a width L of the sheet glass is too small, a mounting step of the wiring board becomes difficult. In addition, the cooling rate of the glass is increased and the fictive temperature thereof tends to be increased. As a result, the dielectric loss is liable to be increased. Meanwhile, when the width L of the sheet glass is too large, a flat smooth sheet is hardly obtained owing to an uneven thickness, warping, or the like. Accordingly, a lower limit of the width L is preferably 5 mm or more, 10 mm or more, 15 mm or more, 20 mm or more, 25 mm or more, 30 mm or more, 35 mm or more, 40 mm or more, or 45 mm or more, particularly preferably 50 mm or more. Meanwhile, an upper limit of the width L is preferably 1,000 mm or less, 900 mm or less, 800 mm or less, 700 mm or less, 600 mm or less, 500 mm or less, 400 mm or less, or 350 mm or less, particularly preferably 300 mm or less.

When a value of a ratio "t/L" of the thickness "t" to the width L of the sheet glass is too small, the cooling rate of the glass is increased and the fictive temperature thereof tends to be increased. As a result, the dielectric loss is liable to be increased. Meanwhile, when the value of the ratio "t/L" is too large, a glass content in a prepreg employing the glass substrate of the present invention, for example, increases, and hence the dielectric loss of the prepreg as a whole may be increased. Accordingly, a lower limit of the value of the ratio "t/L" is preferably 0.01×10⁻³ or more, 0.02×10⁻³ or more, or 0.03×10⁻³ or more, particularly preferably 0.04×10⁻³ or more. Meanwhile, an upper limit of the value of the ratio "t/L" is preferably 40×10⁻³ or less, 35×10⁻³ or less, 30×10⁻³ or less, or 25×10⁻³ or less, particularly preferably 20×10⁻³ or less.

In the glass substrate for reinforcing a wiring board of the present invention, the sheet glass has as a glass composition, in terms of mol%, a content of SiO₂+Al₂O₃+B₂O₃ of preferably 87% or more or 87.5% or more, particularly preferably 88% or more. When the content of SiO₂+Al₂O₃+B₂O₃ is too small, the amount of a network-forming oxide in the glass is reduced and the amount of non-crosslinked oxygen is increased. As a result, as the fictive temperature of the sheet glass increases, the glass structure is liable to become disordered, and hence the dielectric constant and the dielectric loss tangent tend to be increased. Meanwhile, an upper limit of the content of SiO₂+Al₂O₃+B₂O₃ is not particularly limited and is 100% or less. However, when the content thereof is too large, the viscosity of the glass is increased and the productivity may be reduced. Accordingly, the upper limit of the content of SiO₂+Al₂O₃+B₂O₃ may be 99% or less, 98% or less, 97% or less, 96.8% or less, or 96.5% or less, particularly 96% or less.

SiO₂ is a component that forms a skeleton of a network structure in the glass, and is also a component that reduces a dielectric constant and a dielectric loss tangent. When the content of SiO₂ is too small, it is difficult to obtain the above-mentioned effects. Meanwhile, when the content of SiO₂ is too large, the solubility of raw materials is reduced, and it becomes difficult to obtain homogeneous glass. In addition, a forming temperature tends to be increased, which results in a reduction in productivity. Accordingly, a suitable lower limit range of the content of SiO₂ is 57% or more, 58% or more, 59% or more, 60% or more, or 64% or more, and a suitable upper limit range thereof is 80% or less, less than 80%, or 79% or less, most preferably 78% or less.

Al₂O₃ is a component that forms the skeleton of the glass, and suppresses phase separation of the glass to stabilize the glass. However, when the content of Al₂O₃ is too large, the dielectric constant and the dielectric loss tangent are liable to be increased. Accordingly, a suitable upper limit range of the content of Al₂O₃ is 20% or less, 19% or less, 18% or less, 17% or less, 16% or less, 15% or less, 13% or less, 12% or less, 11% or less, 10% or less, 9% or less, 8% or less, 7% or less, or 6% or less, particularly 5% or less. A lower limit range of the content of Al₂O₃ is not particularly limited, and is 0% or more, but in order to obtain the above-mentioned effects, is preferably 0.01% or more, particularly preferably 0.015% or more.

As with SiO₂, B₂O₃ is a component that forms the skeleton of the glass, and is also a component that reduces the dielectric constant and the dielectric loss tangent. When the content of B₂O₃ is too small, it is difficult to obtain the above-mentioned effects. Meanwhile, when the content of B₂O₃ is too large, the glass is liable to undergo phase separation, which may result in a reduction in productivity. Accordingly, a suitable lower limit range of the content of B₂O₃ is 10% or more, 11% or more, 12% or more, 13% or more, or 15% or more, particularly 16% or more, and a suitable upper limit range thereof is 30% or less or 28% or less, particularly 27% or less.

The following components may be incorporated as glass components for forming the sheet glass in addition to SiO₂, Al₂O₃, and B₂O₃.

MgO is a component that reduces the viscosity of the glass, and is also a component that is less liable to increase the dielectric constant and the dielectric loss tangent than alkali metal components, such as Li₂O, Na₂O, and K₂O. MgO has a suppressing effect on a dielectric loss caused by transfer of an alkali metal ion when MgO coexists with an alkali metal element. However, when the content of MgO is too large, the phase separation may be promoted. This tendency is noticeable particularly in a glass composition system in which the content of Al₂O₃ is small. Accordingly, a suitable upper limit range of the content of MgO is 15% or less, 13% or less, 10% or less, 9% or less, or 8% or less, particularly 7% or less. A lower limit range of the content of MgO is not particularly limited, and is 0% or more, but in order to obtain the above-mentioned effects, is preferably 0.01% or more, 0.05% or more, or 0.07% or more, particularly preferably 0.1% or more.

As with MgO, CaO is a component that reduces the viscosity of the glass, and is also a component that is less liable to increase the dielectric constant and the dielectric loss tangent than the alkali metal components, such as Li₂O, Na₂O, and K₂O. CaO has a suppressing effect on the transfer of an alkali metal ion when CaO coexists with an alkali metal element. However, when the content of CaO is too large, the phase separation may be promoted. This tendency is noticeable particularly in a glass composition system in which the content of Al₂O₃ is small. Accordingly, a suitable upper limit range of the content of CaO is 15% or less, 13% or less, 10% or less, or 9% or less, particularly 8% or less. A lower limit range of the content of CaO is not particularly limited, and is 0% or more, but in order to obtain the above-mentioned effects, is preferably 0.01% or more, 0.05% or more, or 0.07% or more, particularly preferably 0.1% or more.

As with MgO and CaO, SrO is a component that reduces the viscosity of the glass, and is also a component that is less liable to increase the dielectric constant and the dielectric loss tangent than the alkali metal components, such as Li₂O, Na₂O, and K₂O. SrO has a suppressing effect on the transfer of an alkali metal ion when SrO coexists with an alkali metal element. However, when the content of SrO is too large, the phase separation may be promoted. This tendency is noticeable particularly in a glass composition system in which the content of Al₂O₃ is small. Accordingly, a suitable upper limit range of the content of SrO is 5% or less, 4% or less, 3% or less, 2% or less, 1.5% or less, 1% or less, 0.8% or less, 0.7% or less, 0.6% or less, 0.5% or less, 0.4% or less, 0.3% or less, 0.2% or less, or 0.1% or less, particularly less than 0.1%. A lower limit range of the content of SrO is not particularly limited, and is 0% or more, but in order to obtain the above-mentioned effects, is preferably 0.01% or more or 0.05% or more, particularly preferably 0.07% or more.

As with MgO and CaO, BaO is a component that reduces the viscosity of the glass, and is also a component that is less liable to increase the dielectric constant and the dielectric loss tangent than the alkali metal components, such as Li₂O, Na₂O, and K₂O. BaO has a suppressing effect on the transfer of an alkali metal ion when BaO coexists with an alkali metal element. However, when the content of BaO is too large, the phase separation may be promoted. This tendency is noticeable particularly in a glass composition system in which the content of Al₂O₃ is small. Accordingly, a suitable upper limit range of the content of BaO is 5% or less, 4% or less, 3% or less, 2% or less, or 1.5% or less, particularly 1% or less, further particularly less than 0.1%. A lower limit range of the content of BaO is not particularly limited, and is 0% or more, but in order to obtain the above-mentioned effects, is preferably 0.01% or more, 0.05% or more, or 0.07% or more, particularly preferably 0.1% or more.

As with MgO and CaO, ZnO is a component that reduces the viscosity of the glass, and is also a component that is less liable to increase the dielectric constant and the dielectric loss tangent than the alkali metal components, such as Li₂O, Na₂O, and K₂O. ZnO has a suppressing effect on the transfer of an alkali metal ion when ZnO coexists with an alkali metal element. However, when the content of ZnO is too large, the phase separation may be promoted. This tendency is noticeable particularly in a glass composition system in which the content of Al₂O₃ is small. Accordingly, a suitable upper limit range of the content of ZnO is 5% or less, 4% or less, 3% or less, 2% or less, or 1.5% or less, particularly 1% or less. A lower limit range of the content of ZnO is not particularly limited, and is 0% or more, but in order to obtain the above-mentioned effects, is preferably 0.01% or more, 0.05% or more, or 0.07% or more, particularly preferably 0.1% or more.

Li₂O is a component that reduces the viscosity of the glass, and is also a component that is capable of facilitating the production of the glass to reduce the production cost. However, when the content thereof is too large, the dielectric constant and the dielectric loss tangent are liable to be increased. In addition, when the glass substrate of the present invention is used as a wiring board and the wiring board is subjected to an environment at high temperature and high humidity, a Li₂O component may elute from the glass and the Li₂O component may be deposited in wiring portions in the wiring board, which may inhibit electric signals. Accordingly, a suitable upper limit range of the content of Li₂O is 3% or less, 2.5% or less, 2.3% or less, 2.1% or less, 2.0% or less, 1.5% or less, or 1.4% or less, particularly 1.3% or less. Meanwhile, a lower limit range of the content of Li₂O is not particularly limited, and is 0% or more, but in order to obtain the above-mentioned effects, is preferably 0.001% or more, 0.005% or more, 0.01% or more, or 0.02% or more, particularly preferably 0.05% or more.

As with Li₂O, Na₂O is a component that reduces the viscosity of the glass, and is also a component that is capable of facilitating the production of the glass to reduce the production cost. However, when the content thereof is too large, the dielectric constant and the dielectric loss tangent are liable to be increased. In addition, when the glass substrate of the present invention is used as a wiring board and the wiring board is subjected to an environment at high temperature and high humidity, a Na₂O component may elute from the glass and the Na₂O component may be deposited in wiring portions in the wiring board, which may inhibit electric signals. Accordingly, a suitable upper limit range of the content of Na₂O is 3% or less or 2.4% or less, particularly 2.3% or less. Meanwhile, a lower limit range of the content of Na₂O is not particularly limited, and is 0% or more, but in order to obtain the above-mentioned effects, is preferably 0.01% or more, 0.05% or more, 0.08% or more, 0.1% or more, 0.5% or more, or 0.8% or more, particularly preferably 1% or more.

As with Li₂O and Na₂O, K₂O is a component that reduces the viscosity of the glass, and is also a component that is capable of facilitating the production of the glass to reduce the production cost. However, when the content thereof is too large, the dielectric constant and the dielectric loss tangent are liable to be increased. In addition, when the glass substrate of the present invention is used as a wiring board and the wiring board is subjected to an environment at high temperature and high humidity, a K₂O component may elute from the glass and the K₂O component may be deposited in wiring portions in the wiring board, which may inhibit electric signals. Accordingly, a suitable upper limit range of the content of K₂O is 3% or less or 2.4% or less, particularly 2.3% or less. Meanwhile, a lower limit range of the content of K₂O is not particularly limited, and is 0% or more, but in order to obtain the above-mentioned effects, is preferably 0.01% or more, 0.05% or more, or 0.08% or more, particularly preferably 0.1% or more.

When the content of Li₂O+Na₂O+K₂O (total content of Li₂O, Na₂O, and K₂O) is too large, the dielectric constant and the dielectric loss tangent are liable to be increased. In addition, when the glass substrate of the present invention is used as a wiring board and the wiring board is subjected to an environment at high temperature and high humidity, the Na₂O component, the Li₂O component, and/or the K₂O component may elute from the glass and those components may be deposited in wiring portions in the wiring board, which may inhibit electric signals. Accordingly, a suitable upper limit range of the content of Li₂O+Na₂O+K₂O is 6% or less, 5.5% or less, or 5% or less. Meanwhile, a lower limit range of the content of Li₂O+Na₂O+K₂O is not particularly limited, and is 0% or more, but in order to obtain the above-mentioned effects, is preferably 0.1% or more, 0.3% or more, or 0.5% or more, particularly preferably 1% or more. Li₂O, Na₂O, and K₂O are each a component that is liable to elute from the glass, but their elution can be suppressed by causing these components to coexist with each other to inhibit their transfer in the glass. Accordingly, it is preferred that two kinds or three kinds of those components be mixed and incorporated into the glass.

ZrO₂ is a component that improves the chemical durability of the glass. However, when the content of ZrO₂ is too large, a liquidus temperature is increased, and devitrification occurs at the time of forming, which may result in a reduction in production efficiency. Accordingly, a suitable upper limit range of the content of ZrO₂ is 1.5% or less, 1.3% or less, 1.2% or less, 1% or less, 0.5% or less, 0.1% or less, or 0.05% or less, particularly 0.03% or less. Meanwhile, a lower limit range of the content of ZrO₂ is not particularly limited, and is 0% or more, but in order to obtain the above-mentioned effects, is preferably 0.001% or more or 0.003% or more, particularly preferably 0.005% or more.

Fe₂O₃ is a component that has a fining action. However, when the content of Fe₂O₃ is too large, the dielectric constant and the dielectric loss tangent may be increased. Accordingly, a suitable upper limit range of the content of Fe₂O₃ is 0.15% or less, 0.1% or less, or 0.09% or less, particularly 0.08% or less. Meanwhile, a lower limit range of the content of Fe₂O₃ is not particularly limited, and is 0% or more, but in order to obtain the above-mentioned effects, is preferably 0.0001% or more, 0.0005% or more, 0.001% or more, 0.005% or more, 0.006% or more, 0.007% or more, 0.008% or more, 0.009% or more, 0.010% or more, 0.011% or more, or 0.012% or more, particularly preferably 0.013% or more.

Also SnO₂ is a component that has a fining action. Specifically, SnO₂ emits an oxygen gas at 1,500°C or more through a change in valence of Sn in accordance with the temperature of molten glass. However, when the content thereof is large, absorption of light in a visible region is increased, and the glass may be colored. Accordingly, a suitable upper limit range of the content of SnO₂ is 0.5% or less, 0.45% or less, 0.4% or less, or 0.35% or less, particularly 0.3% or less. Meanwhile, a lower limit range of the content of SnO₂ is not particularly limited, and is 0% or more, but in order to obtain the above-mentioned effects, is preferably 0.01% or more or 0.02% or more, particularly preferably 0.05% or more. When the contents of the alkali metal components, such as Li₂O, Na₂O, and K₂O, are small, the melting temperature is liable to be increased. SO₃, which similarly has a fining action, is decomposed at 1,400°C or more to emit a SO₂ gas. When the gas is emitted under a state in which the viscosity of the molten glass is high, sufficient bubble breaking cannot be expected. In such case, the use of SnO₂ as a fining agent is preferred.

Also F is a component that has a fining action. In addition, F has a reducing effect on the viscosity of the molten glass. However, when the content thereof is large, an environmental load may be increased, or a melting facility may be corroded. Accordingly, a suitable upper limit range of the content of F is 0.5% or less, 0.3% or less, or 0.2% or less, particularly 0.1% or less. Meanwhile, a lower limit range of the content of F is not particularly limited, and is 0% or more, but in order to obtain the above-mentioned effects, is preferably 0.01% or more or 0.02% or more, particularly preferably 0.05% or more.

Also Cl is a component that has a fining action. In addition, Cl has a reducing effect on the viscosity of the molten glass. However, when the content thereof is large, an environmental load may be increased, or a melting facility may be corroded. Accordingly, a suitable upper limit range of the content of Cl is 0.5% or less, 0.3% or less, or 0.2% or less, particularly 0.1% or less. Meanwhile, a lower limit range of the content of Cl is not particularly limited, and is 0% or more, but in order to obtain the above-mentioned effects, is preferably 0.01% or more or 0.02% or more, particularly preferably 0.05% or more.

When a composition having a large content of B₂O₃ is melted by combustion heating, the amount of evaporation of B₂O₃ from a glass melt becomes large. Accordingly, heating by passing electricity through glass may be performed. For example, MoO₃ is used as an electrode for passing electricity through glass, but MoO₃ may melt into the glass melt. When MoO₃ and a polyvalent metal oxide, such as Fe₂O₃ or SnO₂, coexist, an oxidation-reduction reaction occurs between the polyvalent metal oxides, which may result in coloring of the glass. Accordingly, a suitable upper limit range of the content of MoO₃ in the glass is 1,000 ppm or less, 900 ppm or less, 700 ppm or less, 500 ppm or less, or 300 ppm or less, particularly 200 ppm or less. Meanwhile, a lower limit range of the content of MoO₃ is not particularly limited, and is 0 ppm or more, but MoO₃ may be incorporated in the range of 0.01 ppm or more or 0.02 ppm or more, particularly 0.03 ppm or more.

In addition, TiO₂ may be incorporated in the range of 5% or less or 1% or less, particularly less than 0.2% in addition to the above-mentioned components.

The dielectric loss tangent is easily affected by polarization, and is hence easily affected by the difference in electronegativity between a constituent element (constituent element excluding an oxygen atom) of each component and an oxygen atom. Specifically, when the amount of a network-forming oxide, such as SiO₂, Al₂O₃, or B₂O₃, is large, a glass structure is hardly deformed by a change in electric field, and hence the dielectric loss tangent is likely to be reduced. Meanwhile, when the amount of a modifier oxide, such as Li₂O, Na₂O, K₂O, MgO, CaO, SrO, or BaO, is large, the glass structure or the local polarization is liable to change by a change in electric field, and hence the dielectric loss tangent is liable to be increased. In addition, when the amount of the modifier oxide is large, the glass structure becomes fragile, and in particular, when the fictive temperature is high, the glass structure is frozen in a state of being disordered. Thus, the dielectric loss tangent is liable to be increased. In view of the foregoing, a value of the ratio NWF/NWM of an electronegativity of a network-forming oxide to an electronegativity of a modifier oxide is preferably 5 or more, 7 or more, 8 or more, 9 or more, 10 or more, 12 or more, 12.5 or more, 13 or more, 13.5 or more, 14 or more, 14.5 or more, 14.8 or more, or 14.9 or more, particularly preferably 15 or more. Meanwhile, when the value of the ratio NWF/NWM increases, the melting temperature increases, and hence the productivity is reduced. Accordingly, an upper limit of the ratio NWF/NWM is preferably 160 or less, 155 or less, 150 or less, 145 or less, 100 or less, 50 or less, 40 or less, or 30 or less, particularly preferably 20 or less.

The values of NWF and NWM may be calculated by the following equations by using the content (mol%) of each component and the difference in electronegativity between each element and the oxygen atom. The difference in electronegativity is calculated by using values of Pauling electronegativity shown in Table 1.

NWF=Σ(content of network-forming oxide×coefficient of constituent element of network-forming oxide×difference ΔX in electronegativity between constituent element of network-forming oxide and oxygen atom)

NWM=Σ(content of modifier oxide×coefficient of constituent element of modifier oxide×difference ΔX in electronegativity between constituent element of modifier oxide and oxygen atom)

**Table 1**

| Constituent element | Electronegativity | Difference ΔX in electronegativity from oxygen atom |
|---|---|---|
| Si | 1.90 | 1.54 |
| Al | 1.61 | 1.83 |
| B | 2.04 | 1.40 |
| P | 2.19 | 1.25 |
| Li | 0.98 | 2.46 |
| Na | 0.93 | 2.51 |
| K | 0.82 | 2.62 |
| Mg | 1.31 | 2.13 |
| Ca | 1.00 | 2.44 |
| Sr | 0.95 | 2.49 |
| Ba | 0.89 | 2.55 |
| Ti | 1.55 | 1.89 |
| Zr | 1.33 | 2.11 |
| Fe | 1.83 | 1. 61 |
| Cu | 1.90 | 1.54 |
| Zn | 1.65 | 1.79 |
| Mo | 2.16 | 1.28 |
| S | 2.58 | 0.86 |
| Cl | 3.16 | 0.28 |
| F | 3.98 | -0.54 |
| Sn | 1.96 | 1.48 |
| Sb | 2.05 | 1.39 |
| Ce | 1.12 | 2.32 |
| O | 3.44 | 0 |

### (Characteristics of Glass Substrate)

The glass substrate for reinforcing a wiring board of the present invention preferably has a dielectric constant of 5 or less and a dielectric loss tangent of 0.005 or less at 25°C and a frequency of 40 GHz. When the dielectric constant or the dielectric loss tangent is too large, the dielectric loss is increased and a waveform may be attenuated. This tendency is noticeable particularly in high-frequency applications. Accordingly, a suitable upper limit range of the dielectric constant is 5 or less, 4.9 or less, 4.8 or less, 4.6 or less, 4.5 or less, 4.4 or less, 4.3 or less, or 4.2 or less. The dielectric constant is preferably small, and the lower limit thereof is realistically about 3 in the case of the glass. In addition, a suitable upper limit range of the dielectric loss tangent is 0.005 or less, 0.0045 or less, or 0.004 or less. The dielectric loss tangent is preferably small as well, and the lower limit thereof is realistically about 0.001 in the case of the glass. In addition, a suitable upper limit range of the dielectric loss, which is a value obtained by multiplying the dielectric constant by the dielectric loss tangent, is preferably 0.025 or less, 0.024 or less, 0.023 or less, 0.022 or less, 0.021 or less, or 0.020 or less. The dielectric loss is preferably low, and the lower limit thereof is realistically about 0.003 in the case of the glass.

### (Method of producing Glass Substrate)

First, glass raw materials are blended so as to provide a desired composition, and the mixture is melted in a melting furnace or a melting pot. A natural raw material, a chemical raw material, cullet, and the like may be used as the glass raw materials. A water content in the glass may be adjusted by using a water-containing raw material such as a hydroxide. Examples of a heating method include hydrogen combustion, oxygen combustion, and heating by passing electricity through glass. Two or more kinds of methods out of those methods may be used in combination.

The molten glass is formed and subjected to processing such as cutting as required so as to have a desired shape. Thus, a glass substrate is provided. Examples of a forming method include roll-out forming, overflow forming, slit down-draw forming, redraw forming, and float forming. The glass after the forming may be subjected to chemical polishing, mechanical polishing, etching, or the like to reduce the thickness.

### (Prepreg)

The prepreg of the present invention comprises the above-mentioned sheet glass and a resin layer arranged on at least one main surface of the sheet glass. A silane coupling agent layer is preferably arranged between the sheet glass and the resin layer to improve adhesiveness between the sheet glass and the resin layer. Specifically, it is preferred that a silane coupling agent be applied to the surface of the sheet glass, and a resin layer be arranged on the resultant silane coupling agent layer.

The silane coupling agent may be applied by a method, such as spin coating, dip coating, spray coating, or atomization coating. Just after the production of the sheet glass, the silane coupling agent may be applied to the sheet glass, and curing treatment of the silane coupling agent may be performed while the sheet glass is annealed in an annealer. In addition, the silane coupling agent may be applied while the molten glass is formed into the sheet glass.

Examples of the silane coupling agent include γ-aminopropyltriethoxysilane, N-phenyl-γ-aminopropyltrimethoxysilane, γ-glycidoxypropyltrimethoxysilane, γ-methacryloxypropyltrimethoxysilane, γ-(2-aminoethyl)aminopropyltrimethoxysilane, β-(3,4-epoxycyclohexyl)ethyltrimethoxysilane, N-β-(N-vinylbenzylaminoethyl)-γ-aminopropyltrimethoxysilane hydrochloride, γ-chloropropyltrimethoxysilane, γ-mercaptopropyltrimethoxysilane, and vinyltriethoxysilane. It is preferred that those silane coupling agents be appropriately selected in accordance with the kind of the resin layer to be formed.

An example of a resin to be used for the resin layer is a thermosetting resin. Specific examples of the thermosetting resin include: phenol resins including a novolac-type phenol resin, such as a phenol novolac resin, a cresol novolac resin, or a bisphenol A-type novolac resin, and a resol-type phenol resin, such as an unmodified resol phenol resin, or an oil-modified resol phenol resin modified with wood oil, linseed oil, or walnut oil; epoxy resins including a bisphenol-type epoxy resin, such as a bisphenol A-type epoxy resin, a bisphenol F-type epoxy resin, a bisphenol S-type epoxy resin, a bisphenol E-type epoxy resin, a bisphenol M-type epoxy resin, a bisphenol P-type epoxy resin, or a bisphenol Z-type epoxy resin, a novolac-type epoxy resin, such as a phenol novolac-type epoxy resin or a cresol novolac epoxy resin, a biphenyl-type epoxy resin, a biphenylaralkyl-type epoxy resin, an arylalkylene-type epoxy resin, a naphthalene-type epoxy resin, an anthracene-type epoxy resin, a phenoxy-type epoxy resin, a dicyclopentadiene-type epoxy resin, a norbornene-type epoxy resin, an adamantane-type epoxy resin, and a fluorene-type epoxy resin; urea resins; resins each having a triazine ring such as a melamine resin; and unsaturated polyester resins, bismaleimide resins (BT resins), polyurethane resins, diallyl phthalate resins, silicone resins, resins each having a benzoxazine ring, and cyanate resins. Those resins may be used alone or in combination thereof. When one kind of resin is used, two or more kinds having different weight-average molecular weights may be used in combination. The resin may be used in combination with a prepolymer thereof.

### Examples

The present invention is described below by way of Examples. However, the present invention is not limited to these Examples.

Examples 1 to 16 and Comparative Example 1 of the present invention are shown in Tables 2 to 5.

**Table 2**

| | | Example 1 | Example 2 | Example 3 | Example 4 | Example 5 |
|---|---|---|---|---|---|---|
| SiO₂ | mol% | 77.1 | 77.1 | 77.1 | 77.1 | 64.1 |
| Al₂O₃ | | 0.1 | 0.1 | 0.1 | 0.1 | 5.0 |
| B₂O₃ | | 17.3 | 17.3 | 17.3 | 17.3 | 24.8 |
| MgO | | 0.6 | 0.6 | 0.6 | 0.6 | 1.0 |
| CaO | | 0.7 | 0.7 | 0.7 | 0.7 | 5.0 |
| SrO | | 0.0 | 0.0 | 0.0 | 0.0 | 0.0 |
| BaO | | 0.0 | 0.0 | 0.0 | 0.0 | 0.0 |
| Li₂O | | 1.9 | 1.9 | 1.9 | 1.9 | 0.0 |
| Na₂O | | 1. 58 | 1. 58 | 1. 58 | 1. 58 | 0.01 |
| K₂O | | 0.72 | 0.72 | 0.72 | 0.72 | 0.003 |
| SnO₂ | | 0.10 | 0.10 | 0.10 | 0.10 | 0.08 |
| Fe₂O₃ | | 0.014 | 0.014 | 0.014 | 0.014 | 0.0137 |
| ZrO₂ | | 0.015 | 0.015 | 0.015 | 0.015 | 0.012 |
| NWF/NWM | - | 7.0 | 7.0 | 7.0 | 7.0 | 12.8 |
| SiO₂+Al₂O₃+B₂O₃ | mol% | 94.5 | 94.5 | 94.5 | 94.5 | 93.9 |
| Li₂O+Na₂O+K₂O | | 4.2 | 4.2 | 4.2 | 4.2 | 0.013 |
| Thickness "t" | µm | 148 | 148 | Not measured | Not measured | Not measured |
| Width L | mm | 40 | 40 | Not measured | Not measured | Not measured |
| t/L | - | 3.7 | 3.7 | Not measured | Not measured | Not measured |
| Fictive temperature | °C | 580 | 680 | 780 | 800 | Not measured |
| Viscosity at fictive temperature | - | 10^10.9 | 10^9.2 | Not measured | Not measured | Not measured |
| Glass transition point Tg | °C | 593 | 593 | 593 | 593 | Not measured |
| Fictive temperature-Tg | | -13 | 87 | 187 | 207 | Not measured |
| Strain point | | - | - | - | - | 550 |
| Annealing point | | - | - | - | - | 610 |
| Softening point | | 805 | 805 | 805 | 805 | Not measured |
| 10^4 | | 1,096 | 1,096 | 1,096 | 1,096 | 1,275 |
| 10^3 | | 1,326 | 1,326 | 1,326 | 1,326 | 1,470 |
| 10^2.5 | | 1,406 | 1,406 | 1,406 | 1,406 | 1,590 |
| Dielectric constant (40 GHz) | - | 4.1 | 4.1 | Not measured | Not measured | Not measured |
| Dielectric loss tangent (40 GHz) | - | 0.0035 | 0.0044 | Not measured | Not measured | Not measured |
| Dielectric loss (40 GHz) | - | 0.0145 | 0.0182 | Not measured | Not measured | Not measured |
| Young's modulus | GPa | Not measured | Not measured | Not measured | Not measured | Not measured |

**Table 3**

| | | Example 6 | Example 7 | Example 8 | Example 9 | Example 10 |
|---|---|---|---|---|---|---|
| SiO₂ | mol% | 66.0 | 66.0 | 66.0 | 66.0 | 66.0 |
| Al₂O₃ | | 4.2 | 4.2 | 4.2 | 4.2 | 4.2 |
| B₂O₃ | | 25.7 | 25.7 | 25.7 | 25.7 | 25.7 |
| MgO | | 1.0 | 1.0 | 1.0 | 1.0 | 1.0 |
| CaO | | 3.0 | 3.0 | 3.0 | 3.0 | 3.0 |
| SrO | | 0.0 | 0.0 | 0.0 | 0.0 | 0.0 |
| BaO | | 0.0 | 0.0 | 0.0 | 0.0 | 0.0 |
| Li₂O | | 0.0 | 0.0 | 0.0 | 0.0 | 0.0 |
| Na₂O | | 0.01 | 0.01 | 0.01 | 0.01 | 0.01 |
| K₂O | | 0.01 | 0.01 | 0.01 | 0.01 | 0.01 |
| SnO₂ | | 0.1 | 0.1 | 0.1 | 0.1 | 0.1 |
| Fe₂O₃ | | 0.015 | 0.015 | 0.015 | 0.015 | 0.015 |
| ZrO₂ | | 0.01 | 0.01 | 0.01 | 0.01 | 0.01 |
| NWF/NWM | - | 19.4 | 19.4 | 19.4 | 19.4 | 19.4 |
| SiO₂+Al₂O₃+B₂O₃ | mol% | 95.9 | 95.9 | 95.9 | 95.9 | 95.9 |
| Li₂O+Na₂O+K₂O | | 0.02 | 0.02 | 0.02 | 0.02 | 0.02 |
| Thickness "t" | µm | 150 | 150 | 150 | 150 | 150 |
| Width L | mm | 30 | 30 | 30 | 30 | 30 |
| t/L | - | 5.0 | 5.0 | 5.0 | 5.0 | 5.0 |
| Fictive temperature | °C | 610 | 660 | 700 | 760 | 800 |
| Viscosity at fictive temperature | - | 10^12.2 | 10^11.3 | 10^10.6 | 10^9.7 | 10^9.1 |
| Glass transition point Tg | °C | 600 | 600 | 600 | 600 | 600 |
| Fictive temperature-Tg | | 10 | 60 | 100 | 160 | 200 |
| Strain point | | 514 | 514 | 514 | 514 | 514 |
| Annealing point | | 576 | 576 | 576 | 576 | 576 |
| Softening point | | 890 | 890 | 890 | 890 | 890 |
| 10^4 | | 1,316 | 1,316 | 1,316 | 1, 316 | 1,316 |
| 10^3 | | 1,522 | 1,522 | 1,522 | 1,522 | 1,522 |
| 10^2.5 | | 1,645 | 1,645 | 1,645 | 1, 645 | 1,645 |
| Dielectric constant (40 GHz) | - | 4.0 | 4.0 | 3.6 | 3.9 | Not measured |
| Dielectric loss tangent (40 GHz) | - | 0.0020 | 0.0026 | 0.0032 | 0.0033 | Not measured |
| Dielectric loss (40 GHz) | - | 0.0080 | 0.0105 | 0.0115 | 0.0129 | Not measured |
| Young's modulus | GPa | Not measured | Not measured | Not measured | Not measured | Not measured |

**Table 4**

| | | Example 11 | Example 12 | Example 13 | Example 14 | Example 15 |
|---|---|---|---|---|---|---|
| SiO₂ | mol% | 65.5 | 66.3 | 64.2 | 64.2 | 64.2 |
| Al₂O₃ | | 3.0 | 4.7 | 6.3 | 6.3 | 6.3 |
| B₂O₃ | | 27.4 | 24.9 | 23.2 | 23.2 | 23.2 |
| MgO | | 3.0 | 1.0 | 1.6 | 1.6 | 1.6 |
| CaO | | 1.0 | 2.8 | 4.6 | 4.6 | 4. 6 |
| SrO | | 0.0 | 0.2 | 0.0 | 0.0 | 0.0 |
| BaO | | 0.0 | 0.0 | 0.0 | 0.0 | 0.0 |
| Li₂O | | 0.0 | 0.0 | 0.0 | 0.0 | 0.0 |
| Na₂O | | 0.02 | 0.02 | 0.01 | 0.01 | 0.01 |
| K₂O | | 0.005 | 0.001 | 0.01 | 0.01 | 0.01 |
| SnO₂ | | 0.09 | 0.09 | 0.1 | 0.1 | 0.1 |
| Fe₂O₃ | | 0.0131 | 0.0133 | 0.015 | 0.015 | 0.015 |
| ZrO₂ | | 0.012 | 0.01 | 0.02 | 0.02 | 0.02 |
| NWF/NWM | - | 20.6 | 19.4 | 12.5 | 12.5 | 12.5 |
| SiO₂+Al₂O₃+B₂O₃ | mol% | 95.9 | 95.9 | 93.7 | 93.7 | 93.7 |
| Li₂O+Na₂O+K₂O | | 0.025 | 0.021 | 0.02 | 0.02 | 0.02 |
| Thickness "t" | µm | Not measured | Not measured | Not measured | Not measured | Not measured |
| Width L | mm | Not measured | Not measured | Not measured | Not measured | Not measured |
| t/L | - | Not measured | Not measured | Not measured | Not measured | Not measured |
| Fictive temperature | °C | Not measured | Not measured | 670 | 700 | 750 |
| Viscosity at fictive temperature | | Not measured | Not measured | Not measured | Not measured | Not measured |
| Glass transition point Tg | °C | Not measured | Not measured | 637 | 637 | 637 |
| Fictive temperature-Tg | | Not measured | Not measured | 33 | 63 | 113 |
| Strain point | | 520 | 525 | 573 | 573 | 573 |
| Annealing point | | 580 | 589 | 630 | 630 | 630 |
| Softening point | | Not measured | Not measured | - | - | - |
| 10^4 | | 1,333 | 1,325 | 1,266 | 1,266 | 1,266 |
| 10^3 | | 1,540 | 1,525 | 1,451 | 1,451 | 1,451 |
| 10^2.5 | | 1, 670 | 1, 648 | 1,565 | 1,565 | 1,565 |
| Dielectric constant (40 GHz) | | Not measured | Not measured | Not measured | Not measured | Not measured |
| Dielectric loss tangent (40 GHz) | | Not measured | Not measured | Not measured | Not measured | Not measured |
| Dielectric loss (40 GHz) | | Not measured | Not measured | Not measured | Not measured | Not measured |
| Young's modulus | GPa | Not measured | Not measured | Not measured | Not measured | Not measured |

**Table 5**

| | | Example 16 | Comparative Example 1 |
|---|---|---|---|
| SiO₂ | mol% | 64.2 | 57.7 |
| Al₂O₃ | | 6.3 | 10.0 |
| B₂O₃ | | 23.2 | 18.0 |
| MgO | | 1.6 | 8.9 |
| CaO | | 4.6 | 4.9 |
| SrO | | 0.0 | 0.0 |
| BaO | | 0.0 | 0.0 |
| Li₂O | | 0.0 | 0.3 |
| Na₂O | | 0.01 | 0.10 |
| K₂O | | 0.01 | 0.0 |
| SnO₂ | | 0.1 | 0.1 |
| Fe₂O₃ | | 0.015 | 0.05 |
| ZrO₂ | | 0.02 | 0.015 |
| NWF/NWM | - | 12.5 | 5.3 |
| SiO₂+Al₂O₃+B₂O₃ | mol% | 93.7 | 85.7 |
| Li₂O+Na₂O+K₂O | | 0.02 | 0.40 |
| Thickness "t" | µm | Not measured | 150 |
| Width L | mm | Not measured | 40 |
| t/L | - | Not measured | 3.8 |
| Fictive temperature | °C | 800 | 680 |
| Viscosity at fictive temperature | - | Not measured | Not measured |
| Glass transition point Tg | °C | 637 | 630 |
| Fictive temperature-Tg | | 163 | 50 |
| Strain point | | 573 | - |
| Annealing point | | 630 | - |
| Softening point | | - | - |
| 10^4 | | 1,266 | 1,132 |
| 10^3 | | 1,451 | 1,284 |
| 10^2.5 | | 1,565 | 1,494 |
| Dielectric constant (40 GHz) | - | Not measured | 4.8 |
| Dielectric loss tangent (40 GHz) | - | Not measured | 0.0059 |
| Dielectric loss (40 GHz) | - | Not measured | 0.0283 |
| Young's modulus | GPa | Not measured | Not measured |

The samples shown in Tables 2 to 5 were each produced as described below.

First, various glass raw materials, such as a natural raw material and a chemical raw material, were weighed by 500 g in total, and a raw material batch was prepared so that a glass composition obtained after melting became the glass composition shown in each of Tables 1 and 2. The resultant raw material batch was ground and mixed for 20 minutes, loaded into a 300 cc platinum-rhodium crucible, and then heated at from about 1,450°C to about 1,680°C for 6 hours in an air atmosphere in an indirect-heating electric furnace to provide molten glass. The resultant molten glass was poured out onto a carbon sheet, subjected to roll forming with a metal roller so as to achieve a thickness of 5 mm, and left to cool to room temperature. Thus, a glass sample was obtained. The resultant sample was held in an annealer set to each of the fictive temperatures shown in the tables for 1 hour. After that, the sample was quickly taken out of the annealer and immersed in water (20°C) for quenching. In this way, a sample (sheet glass) was obtained.

The resultant samples were each measured for the following characteristics.

The strain point, the annealing point, and the softening point were each measured by a fiber elongation method.

The glass transition point Tg was measured with a dilatometer. When the amount of the sample is small, the glass transition point may also be measured with a differential thermal analyzer (DTA).

The temperature at a viscosity at high temperature of 10⁴ dPa·s, the temperature at a viscosity at high temperature of 10³ dPa·s, and the temperature at a viscosity at high temperature of 10^{2.5} dPa·s (represented as "10^4", "10^3", and "10^2.5", respectively in the tables) were each measured as follows: part of a glass sample obtained by the above-mentioned method was crushed in advance so as to achieve a proper size; the resultant was loaded into a platinum crucible to be reheated to a molten state; and then the measurement was performed by a platinum sphere pull up method.

The viscosity at a fictive temperature was calculated by: making a viscosity curve from the strain point, the annealing point, the softening point, the temperature at a viscosity at high temperature of 10⁴ dPa·s, the temperature at a viscosity at high temperature of 10³ dPa·s, and the temperature at a viscosity at high temperature of 10^{2.5} dPa·s measured by the above-mentioned methods; and reading the viscosity corresponding to the fictive temperature from the viscosity curve.

The dielectric constant ε and the dielectric loss tangent tanδ at a frequency of 40 GHz were measured as described below. The glass sample obtained by the above-mentioned method was processed into dimensions of 30 mm×40 mm×0.15 mmt. Both the main surfaces thereof were polished to be mirror finished. The resultant sample was held in an annealer set to each of the fictive temperatures shown in the tables for 1 hour. After that, the sample was quickly taken out of the annealer and immersed in water (20°C) for quenching. The measurement was performed by a split cylinder method with a resonator for 40 GHz and a vector analyzer. In addition, the measurement was performed at room temperature (25°C).

The Young's modulus was measured by using a sample piece obtained from the glass sample obtained by the above-mentioned method and processed into 40 mm×20 mm×2 mm. Both surfaces of the resultant glass sample piece each having a thickness of 2 mm were polished with a polishing liquid obtained by mixing #1200 alumina powder in water. Gold was deposited from the vapor on the sample (thickness of 1,500 Å or more), and the width, length, thickness, and weight of the sample were measured. The measurement was performed by using a free resonance elastic modulus measurement device (JE-RT3, manufactured by Nihon Techno-Plus Co. Ltd.).

As shown in the tables, the glass substrates of Examples 1 to 16 each had a content of SiO₂+Al₂O₃+B₂O₃ of 93.7 mol% or more and a low dielectric loss of 0.0182 or less. Meanwhile, the glass substrate of Comparative Example 1 had a small content of SiO₂+Al₂O₃+B₂O₃ of 85.7 mol% and thus a high dielectric loss of 0.0283.

### Industrial Applicability

The glass substrate of the present invention is suitable for reinforcing a wiring board, such as a printed wiring board, a multilayer wiring board, or a high density semiconductor packaging board, which is used in a high frequency band of 10 GHz or more.

## Claims

1. A glass substrate for reinforcing a wiring board, comprising a sheet glass having as a glass composition, in terms of mol%, a content of SiO₂+Al₂O₃+B₂O₃ of 87% or more, and having a thickness "t" of 5 µm or more and 500 µm or less.

2. The glass substrate for reinforcing a wiring board according to claim 1, wherein the sheet glass has a fictive temperature of a glass transition temperature Tg+300°C or less.

3. The glass substrate for reinforcing a wiring board according to claim 1 or 2, wherein the sheet glass has a width L of 5 mm or more and 1,000 mm or less.

4. The glass substrate for reinforcing a wiring board according to claim 1 or 2, wherein the sheet glass has a value for a ratio "t/L" of the thickness "t" to a width L of 0.01×10^{- 3} or more and 20×10⁻³ or less.

5. The glass substrate for reinforcing a wiring board according to claim 1 or 2, wherein the sheet glass has a dielectric loss of 0.025 or less at 25°C and a frequency of 40 GHz.

6. The glass substrate for reinforcing a wiring board according to claim 1 or 2, wherein the glass substrate for reinforcing a wiring board is used as a prepreg or a core material for a wiring board.

7. A prepreg, comprising:
the sheet glass of claim 1 or 2; and
a resin layer arranged on at least one main surface of the sheet glass.
